Europäisches Patentamt

European Patent Office

Office européen des brevets

(19)

(11) Publication number: 0 194 468
A2

# EUROPEAN PATENT APPLICATION

(12)

(21) Application number: 86101959.4

(22) Date of filing: 16.02.86

(51) Int. Cl.⁴: H 03 K 17/76

A request for correction of the specification, claims and abstract has been filed pursuant to Rule 88 EPC. A decision on the request will be taken during the proceedings before the Examining Division.

(30) Priority: 05.03.85 IT 1976285

(43) Date of publication of application:
17.09.86 Bulletin 86/38

(84) Designated Contracting States:
AT BE CH DE FR GB LI LU NL SE

(71) Applicant: Motta, Tino Giuseppe
Via A. Grandi 143/A
I-20043 Arcore (Milano)(IT)

(71) Applicant: Motta, Natale
Via A. Grandi 143/A
I-20043 Arcore (Milano)(IT)

(71) Applicant: Zappa, Emilia
Via A. Grandi 143/A
I-20043 Arcore (Milano)(IT)

(72) Inventor: Motta, Tino Giuseppe
Via A. Grandi 143/A
I-20043 Arcore (Milano)(IT)

(72) Inventor: Motta, Natale
Via A. Grandi 143/A
I-20043 Arcore (Milano)(IT)

(72) Inventor: Zappa, Emilia
Via A. Grandi 143/A
I-20043 Arcore (Milano)(IT)

(74) Representative: Lecce, Giovanni
Dott. Giovanni Lecce & C. S.r.l. Via G. Negri 10
I-20123 Milano(IT)

(54) Electronic selector switch for the selection and eventual damping of radio and television frequencies.

(57) An electronic selector (1) for the selection and eventual attenuation of radio and television frequencies, preferably operating on the 40 + 200 MHz band and utilizable for the reception of radio and television signals broadcasted either by ether or cable, containing two or more 23 chains, constituted by one or more 3 PIN diodes placed in series, which connect the RF (4) inputs to output 5.

Every 4 input is connected to a source of RF signals and the 5 output to the input of a utilizer set.

The 23 chains are fed in turn by equal or different voltages, both positive and negative, through one or more inputs (10), (11), (12), (13) and (21) or through output 5, to each chain feed corresponds the commutation of the relative 4 input with the 5 output and the interdiction of all the other outputs.

The commutation current of the various 4 inputs is weak and polarizes the other 23 chains with exclusion of the relative 4 entries.

FIG. 1

"ELECTRONIC SELECTOR SWITCH FOR THE SELECTION AND EVENTUAL DAMP-
ING OF RADIO AND TELEVISION FREQUENCIES"

This invention involves an electronic selector switch for
selection and the eventual damping of radio and television frequencies. More particularly; the invention also involves an
electronic selector switch for the selection and eventual damping
of radio and television frequencies preferably operating on the
40 + 200 MHz band and utilizable for the reception of radio and
television signals either by ether or cable.

The selector switch, object of this invention, contains semiconductor circuits through which groups of RF signals possibly
adjacent one to the other, and/or with different signal levels
coming from one or more sources of emission, generic or from
transmitting stations with different or equal orientation and
applied respectively to two or more of the selector switch's inputs, they are conveyed around its output with possible modification of intensity and sent to a received which is rendered
interference free so that the reception of the broadcast
is pleasant and perfect.

For the selection of signals coming from transmitters with different orientation whether adjacent or not, with different signal
levels, at the moment either steerable motorized antennae or
electronic selector switches are used. With motorized antennae
the selection is relatively modest in that in the presence of
varied signal levels, good reception can only be obtained from
medium or high intensity signals. This is caused by the fact
the preamplification of weak signals with wide band amplifiers

2.  0194468

is difficult and almost impossible to obtain, undesirable phenomena occur such as intermodulation with the relative interference to broadcasts received on radio and television when the antenna is pointed towards a group of transmitters where there are one or more groups of higher potency signals which are capable of saturating the preamplifiers.

Due to the scarce efficiency of these antennae, which require a lot of time and experience to find the correct tracking point, electronic selector switches through which the commutation of the inputs is obtained with transistorized preamplifiers have been studied.  However, even these selector switches have their limitations and disadvantages; in order to obtain a discreet separation of inputs at Radio Frequency, a high preamplification on all inputs is necessary, which can in certain conditions, such as in the case of discreet potency signals, produce undesirable effects.

Another disadvantage is due to the fact that the RF tension limit obtainable without interference at output, is very low in the presence of many and high power signals, so that the transistors of the circuit go into saturation.  Due to this it is only possible to get good reception on channels received with major field intensity.  In addition the separation between inputs is fairly modest: around 35 + 40 dB (maximum) obtained with a signal amplification of 30 dB.  In other cases the separation can even be less.  The above mentioned situations therefore cause undesirable phenomena which drastically limit the reception of Radio and Television broadcasts; for example, in the case of transmitters operating on the same frequencies but oriented at

3.                                           0194468

an angle of approximately 90° between them, electronic selector
switches together with correctly tracked antennae are presently
used for the selection of signals, however, even with this
combination the selection is not satisfactory because due to
the scarce separation between inputs, between 30 + 40 dB and to
possible poor quality shielding, the signals of all the transmitters are present in the output, the one chosen is stronger, but
there is a stacking of the others over it and even if these
others are weaker they obscure the vision of the image received
with the formation of lines and streaks and the audio is disturbed by buzzing and background noises.

In other conditions, for example in the presence of signals
coming from different directions but with such intensity that
they require the damping of those coming from one or more
directions, in order to avoid the saturation of the selectors
and receivers due to the scarce separation of the selector's
inputs there is stacking on the signals which are attenuated
at output on the part of the same signals which are picked-up
distortedly by the other antennae and which are sent to the
selector switch output with insufficient attenuation therefore
causing double images, colour defects, audio defects and other
forms of interference.

Ulterior disadvantages are experienced when the present selector
switches must operate in areas in which many signals with different field intensity are received from different directions.
As we have already pointed out, the stronger signals have to be
attenuated to avoid saturation of the selector.  If the stronger

4.

signals come from directions which are different to those of the weaker signals their attenuation causes image stacking and the type of lines and streaks mentioned earlier. The disadvantages can be lessened by the insertion of selective attenuators or wave-traps calibrated on the stronger channels at each selector input. Besides being difficult, this operation in the presence of many strong channels is both expensive and unstable.

If the stronger signals come from the same direction as that of the weaker one and are picked-up by the same antenna, the attenuation of the stronger signals is still necessary in order to avoid the intermodulation by the selector. Selective attenuators calibrated on the stronger channels are necessary in order to pass weaker signals in the selector without interference, this means that the difficult expensive operations mentioned earlier are still indispensable.

Other disadvantages are experienced when selectors with a 20 + 30 dB gain are used to avoid receiver saturation and signals coming from antennae with a 60 + 70 dBmV intensity and therefore giving excellent reception, have to be 15 + 20 dB. In this case, after attenuation signals with a field intensity of only 45 + 50 dBmV are obtained which due to the noise figure which all the transistor amplifiers present, go through the selector and are sent to the receivers without interference but with an evident phenomenon called "snow".

The object of the present invention is to produce an electronic

5.

selector switch which does not have the above mentioned disadvantages.

This invention solves the problem by means of an electronic selector switch for Radio and television frequencies through which the following results are obtained:

a) high separation between the inputs without any amplification of the signals;

b) Secure rapid commutation obtained with Pin diodes, with the possibility of high signal feedthrough;

c) High input and output impedance variability;

d) Excellent linearity in the feedthrough band, which can for example, be of +/- 1.5 dB in the UHF range.

e) Low standing wave ratio on the input and output of the conductor sections, with the possibility of feedthrough of RF signals from the inputs towards the output and vice versa with the same performance;

f) Possibility of feedthrough into the selector and into the selector/receiver interconnection wires of high intensity signals and on wavebands which greatly differ one from the other (VHF, FM, UHF, SHF);

g) low current necessary for the commutation which, for example can be approximately 10mA for each RF input signal up to 1000 mV;

h) Works at a large number of supply voltages for example 5 to 50 V c.c. since the commutation is by means of the circulating current in the working section independently of the supply voltage with which it is obtained.

The advantages achieved with the present invention essentially consist in the fact that signals coming from any transmitting source, groupable in two or more groups of channels which are which are technically compatible, amplified or not and sent respectively to two or more selector inputs, can be selected in such a way that the signals get to the receivers interference free, even if they are conveyed around one single drop wire for television antenna or sent directly to the only input of the receiver tuner.

By means of this expedient, a good receiver which is particularly selective can receive a lot more radio and television programmes even in critical areas where, contrary to what actually occured up to now, due to the present commutation systems applied to receiving antennae or other which degradate the signals before they reach the receivers' TUNER.

Today's selectors can be constructed in various ways and adapted to various, even well known, commutation systems; in particular, they can be constructed with their components erected in the air or on printed circuits; they can also be constructed apart from or incorporated into radio receivers or in portable or non-portable antenna systems and in generic RF commutation systems.

Commutation control can be carried out both with separate systems or through receiver voltage, and the operation of the selector can either be manual or by remote control.

Towards a better understanding of this invention we have made a series of diagrams, enclosed herewith and explained hereunder, with relative references, to give an example of some, but not all of its functions:

Figures 1. 2. and 3. represent some patterns of polarization systems and therefore of one or more selector'sections.

Figure 4. is a cable and trunk schematic diagram for the polarization and function of the selectors, obtained by a combination of the principles illustrated in the preceding figures.

Figures 5. and 6. represent the selector construction patterns with two and four inputs, and

Figure 7. is a cable and trunk schematic diagram for the type of selector illustrated in Figure 3. combined with an electronic attenuator, $\eta$ variable and made with PIN diodes.

With reference to the figures, electronic selector n°1 for radio and television frequencies, consists of one or more PIN diodes 3, placed in series and forming the 23 chains, which connect the RF inputs 4, to the output 5, of selector 1. Each 23 chain is connected at one extremity to an RF input and at the other to a sole 5A point; this point is connected either directly or through polarization circuits, filter and/or insulator, with output 5. Each input 4 is connected to a source of RF signals of the following kinds: single receiving antennae, groups of signals which are already formed, coming from different stations, signals coming from television cameras or other.

The output 5 is connected to the input of a user set, such as a radio/television set or a video recorder or a video tape player or similar, through a feed-cable or similar.

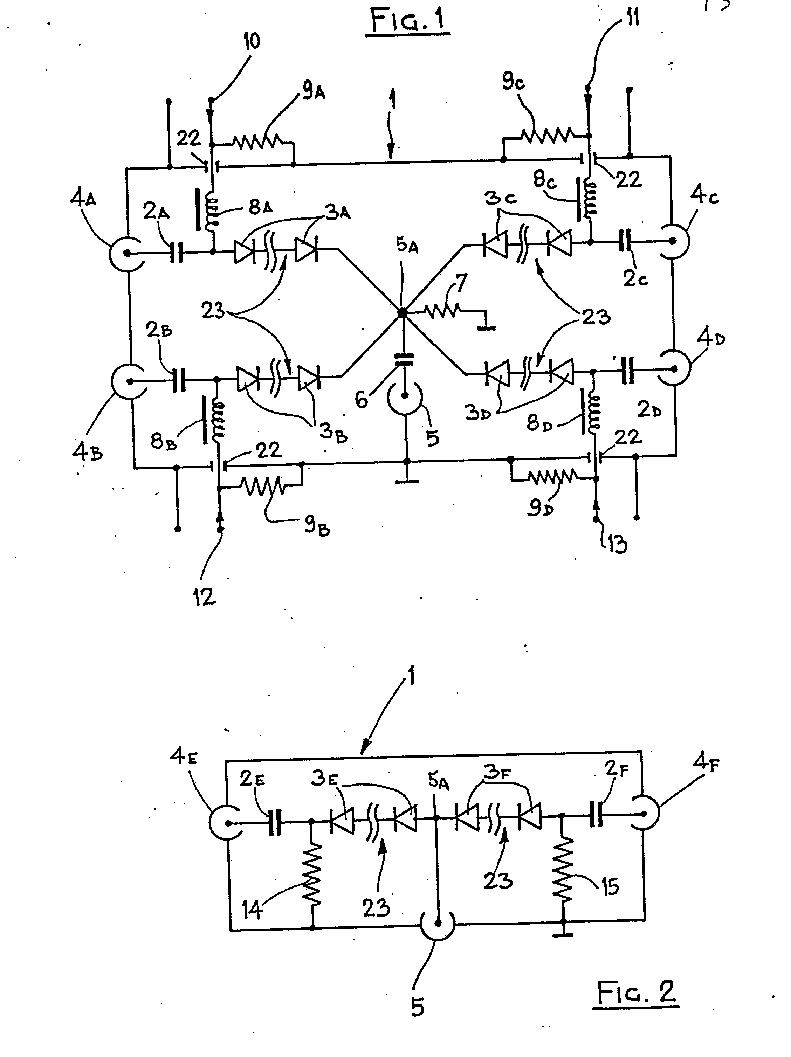

Figure 1. illustrates the way in which it is possible to obtain commutation at radio frequency for a PIN diode selector with two or more inputs; with this system it is possible to create selectors with any number of inputs, since the activation of one of these automatically excludes the feedthrough at radio frequency of the others.

For example, the application of positive voltage, with respect to the mass, on input 10, and none on 11, 12 and 13, through the capacitator feedthrough 22, and the RF 8A block coil, this reaches the 3A PIN diodes. These 3A PIN diodes expose the anode to positive voltage and the mass cathode through resistance 7 and they enter into conduction since a current determined by the voltage applied in 10 and from the resistivity value of resistance 7, runs through them. The radio frequency signals present on input 4A get to the 8A block coil through the 2A isolating capacitator. This 8A coil prevents the transit of signals towards input 10. Finding the diode or diodes 3A in conduction, the RF signals go to resistance 7, which, being of high value (for example: 470 + 1000 Ohm) with respect to the selector impedance (for example: 50 + 90 Ohm) there is a mass discharge on only a small part of these signals, they therefore reach output 5 through the insulation condenser 6 with a minimum loss of approximately 2dB. This loss which is without doubt, acceptably modest, can however be avoided by inserting an RF block coil to resistance 7 which avoids the transit of signals but allows the direct current of polarization to pass.

The bias voltage coming from input 10 is almost completely discharged on resistance 7 due to the minimum voltage drop on the impedance of block 8A and on the 3A diode or diodes.

A positive voltage is therefore exercised on the terminals of resistance 7, with respect to the mass, on the terminal connected to condenser 6 and on the PIN diodes 3.

The positive voltage which is present on resistance 7 interdicts the PIN diodes 3 of all other inputs, 11, 12 and 13, since these are connected to a positive voltage cathode and with a mass anode, through the respective block impedances 8B, 8C and 8D and the 9B 9C and 9D resistances.

The RF signals present on the 4B, 4C and 4D inputs after the respective condensers, 2B, 2C and 2D meet the corresponding 23 chains of the interdicted PIN diodes, therefore, in their transit towards output 5, they undergo drastic attenuation which can for example be as much as 80dB. The maximum attenuation obtainable is in function of the type and number of the PIN diodes 3 used for each 23 chain and of the good screening of the relative elements.

Since an attenuation of the RF signal of approximately 80dB corresponds to an effective reduction of the RF voltage present on the inputs of about 10.000 v, the residue of the signals which pass from the interdicted inputs 4, do not affect the perfect reception of single groups of signals which can be picked-up at output 5 of selector 1.

According to this principle the selection of one of the RF4 inputs can be obtained from selector 1 by applying a positive voltage on the corresponding input for the polarization voltage;

the weak current circulating in the circuit automatically excludes
the other inputs.

Analogously to that which has been said, it is possible to control
the selector with negative voltage with respect to the mass,
by inverting the polarization of the PIN diodes 3.

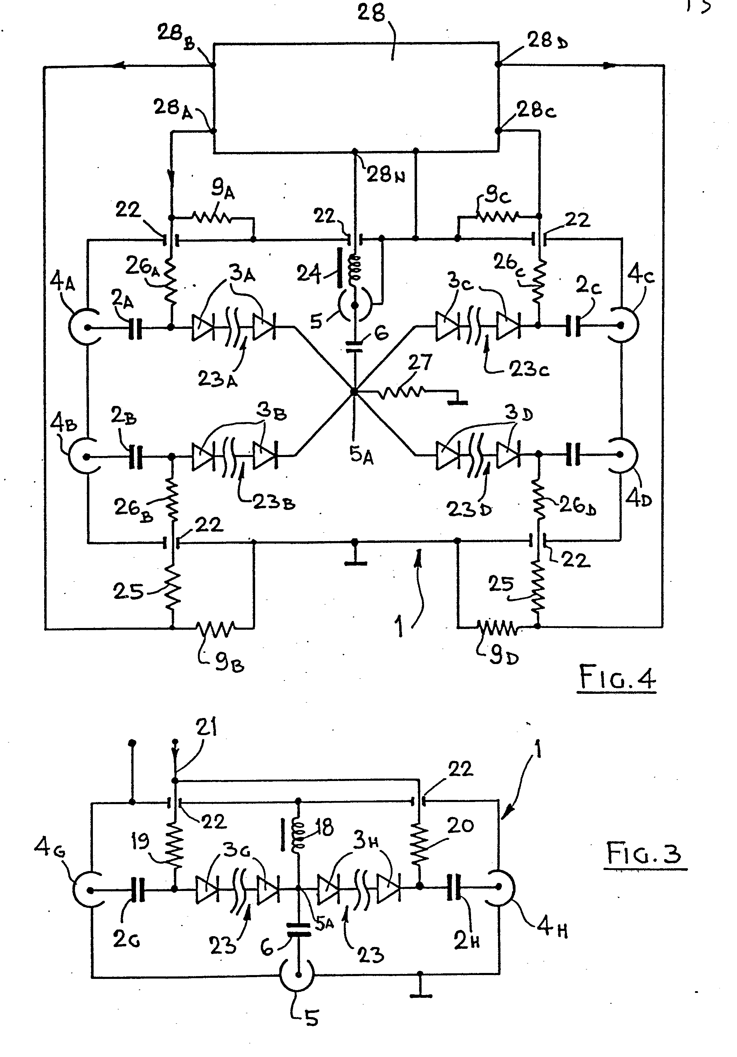

The principal pattern of Figure 2. refers to a selector with
two inputsin which the commutation of the RF4 inputs comes about
by sending either a positive or negative voltage on output 5.

By feeding the selector with positive mass voltage and the
negative to the central conductor of output 5, the 'left circuit'
is excluded, since the corresponding 3E PIN diodes are inversely
polarized by means of resistance 14.  The 3F PIN diodes of
the right circuit are polarized directly through resistance 15,
and enter into conduction with a polarizing current limited
by the same resistance.  In this way the following is achieved:
of all the RF signals applied on the inputs, those applied on the
left 4E input are very strongly attenuated after the passage
of the 2E condenser, whilst those applied on the right 4F input,
after the passage of the 2F isolating condenser, meet resistance
15, which has elevated characteristics and of which only a small
quantity is leaked, then they meet the 3F PIN diodes in conduction
which convey them on output 5.

Also in this case, together with the 14 and 15 resistances
RF block coils can be applied suitable for the reduction of
the transit losses of RF signals in the selector.

By inverting the polarity of the voltage coming from selector 1 the right 23 chain and the corresponding 4F input are interdicted, whilst the left 23 chain and corresponding 4E input go into conduction.

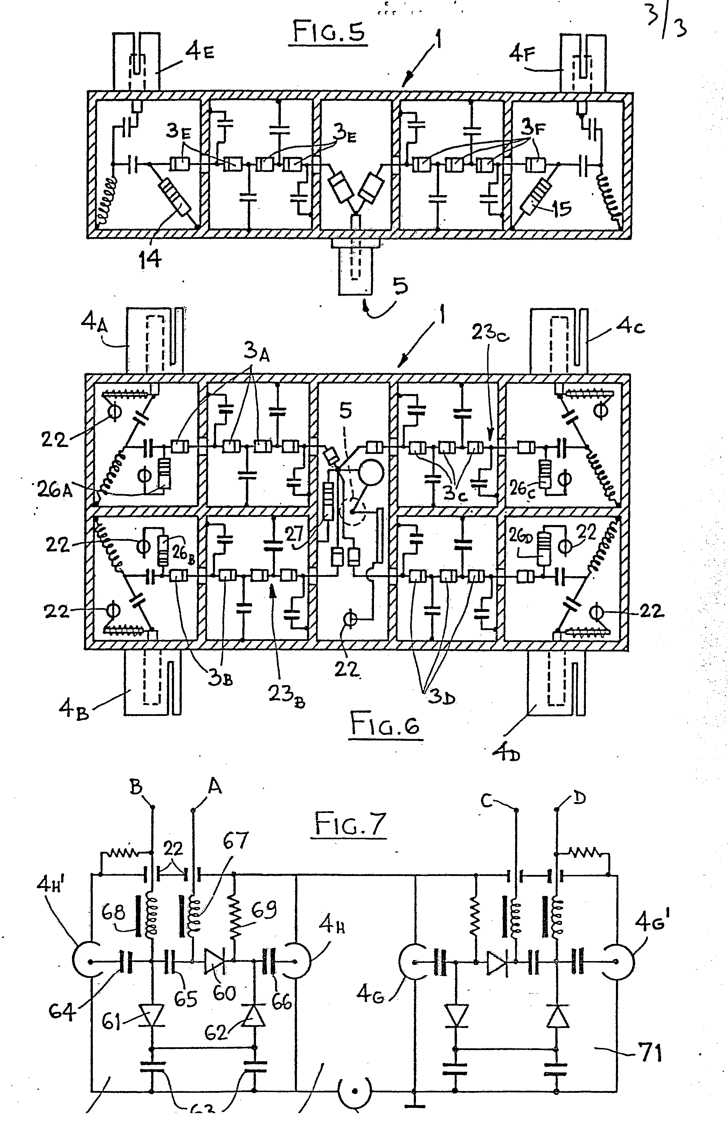

In the pattern of figure 3. the PIN diode selector has two 4 inputs, the commutation of which comes about by sending a positive or negative voltage on input 21, uncoupled from RF signals. In this case also the commutation comes about by conduction or interdiction of one or more PIN diodes; to be exact, in sending a positive voltage with respect to the mass on input 21, through resistance 19, which limits the circulating current and the RF18 impedance block, the 3G PIN diode/diodes enter into conduction and therefore the RF4G input is connected to output 5 through the 2G and 6 isolation condensers. The 3H PIN diodes, on the other hand are inversely polarized through resistance 20 and RF 18 block coil, strongly attenuating the RF signals present on the 4H input. By inverting the polarity of the voltage on input 21 we obtain the conduction of the 3H diodes and the interdiction of the 3G diodes with the consequent passage of the RF signals coming from the 4H input and the attenuation of those coming from the 4G input.

The selector 1, with four inputs, drafted in figure 4. is controlled by a 28 commutation system which serves for the sending to outputs 28A, 28B, 28C, 28D of the control voltages received on the 28N entry through the RF 24 blocked impedance and the 22 passing condenser connected to output 5 of selector 1.

The commutation of the 4 inputs is obtained by means of two voltage levels and two levels of polarity, positive and negative to earth. Sending different voltages in turns on the central contact on output 5, for example + 16 V, - 16 V, + 24 V, - 24 V, with respect to earth, through the 28 commutation system the various 23 chains formed from the 3 PIN diodes which connect the 4 inputs to output 5 can be polarized. In this way only one 23 chain at a time is put into conduction whilst the others are interdicted.

If the selector is fed with a + 16 V voltage for example, through the central contact of the RF 5 output, the voltage reaches the 28N commutation unit through impedance 24 and the passing condenser 22. The 28 commutation unit for example, sends the voltage on the 28A, 28D, and 28C outputs, bringing the 23A chain into conduction formed by one or more 3A PIN diodes, through the 26A and 27 resistances, which more or less present the same resistive value.

In this way, the RF 4A input is connected to the RF 5 of selector 1. The positive voltage which is created across the resistance 27, due to the current present in this, which is approximately half the feed voltage, inversely polarizes the 23B chain of 3B PIN diodes, through the 26B, -25 and 9B resistances which terminate to earth, strongly attenuating the passage of the RF signals present on the 4B input.

The remaining 23C and 23D PIN diode chains which go across the respective 4C and 4D inputs, are inversely polarized by the difference in the feed voltage of + 16 V, applied by the 28 commutation unit on the 28C and 28D outputs and by a voltage of approximately + 5, + 9 V, formed on resistance 27, for the 23A chain conduction.

Analogously to that described above, by feeding selector 1, through the RF5 output, with a voltage of - 16 V, or + 24 V, or - 24 V, the 28 commutation unit sends the 23 PIN diodes 3 chain into conduction, connecting the relative input 4 to the output 5, and placing the other inputs in inverse polarization and strong attenuation of the RF signals passing through these.

With the same constructing concept, by increasing the number of feed to different voltage values, 1 Selectors can be made with a superior number of 4 inputs, in the measure of two inputs for every voltage value added.

In figure 5. a form of realization of a selector with two inputs corresponding to the pattern of figure 2. is represented.

In figure 6. a form of realization of a selector with four inputs corresponding to the pattern of figure 4. is represented.

Figure 7. illustrates the particular pattern of a Selector 1 on the 4H and 4G inputs of which are applied two electronic attenuators at variable $\tau_1$ , 70 and 71, through which the value of transit attenuation in the selector of chosen signals can be regulated from 0 to approximately $\sim$30 dB.

The control of these attenuators together with the selector can either be manual or preferably of the electronic remote control type.

The combination of attenuators/selector can be very useful in the presence of very strong RF signals which could saturate the radio-receivers to which they are connected.

In the illustrated example, the selector 1 paired with the 70 and 71 attenuators, is of the two input type; this does not however exclude the use and pairing with selectors which have more than two inputs.

By applying a positive X voltage on input A of the 70 attenuator, the relative circuit in c.c. is closed by the 67 impedance block, the 60 PIN diode and resistance 69.

The entry into conduction on the part of the 60 PIN diode assures that the RF signal coming from the 4H input, after having crossed the 64 and 65 condensers, the 60 diode and the 66 condenser, can get to the 4H input of selector 1, since the 61 and 62 PIN diodes are interdicted by the voltage present on resistance 69.

If besides the X voltage on input A there is a positive Y voltage applied on input B which is higher, the circuit in c.c. is closed through the 68 impedance block, the 61 and 62 PIN diodes and resistance 69.

Across the 69 resistor a voltage superior to X is formed which interdicts the 60 PIN diode. This interdiction obstructs the passage of the RF signals which must pass through the 61 and 62 PIN diodes.

These diodes, together with the 63 condensers, constitute a $\pi$ attenuator which reduces by about 30 dB the level of the signals present on the 4H input and going to the 4H input of selector 1.

By applying voltages values between X and Y on input B, the attenuation obtained will be between 0 and 30 dB approximately.

15.

The same function is obtained by keeping a constant Y voltage on input B and reducing that of X which is applied in A.

By applying one or more - X and - Y voltages on the C and D inputs of the 71 attenuator, exactly the same results are obtained on the 4G input.

The electronic attenuators described above can therefore be made for both positive and negative voltages.

Mechanical type attenuators or well known amplifiers can be paired with 1 selectors also.

The 3 PIN diodes used in the construction of that described and illustrated, can eventually be substituted with semiconductor single electronic devices with one or more connections which are capable of either blocking or allowing passage of RF signals present on the inputs, in the direction of the outputs, according to the positive or negative polarization applied to the single connections.

For example, by using a MOS-FET where the various 23 chains join in the direction of output 5, it is possible to reduce the number of PIN diodes, obtaining the same results and functions.

From what has been said it is evident that the commutation of selectors is strictly tied to the direct polarization of the PIN diodes of the 23 chain from which RF signals must pass and to the inverse polarization with a voltage of some Volts, of the PIN diodes of the other 23 chains connected to the inputs from which RF signals must not pass.

16.

However if a lesser attenuation is accepted in the interdicted 23 chains, it is possible to avoid the application of this inverse voltage, since polarization voltage is not applied to the 23 chains of the inputs which must be excluded, the PIN diodes connected to the above mentioned 23 chains are automatically blocked, strongly attenuating the signals present on the corresponding inputs, as already described.

In this case it is necessary that the voltage of the RF signals present on the non-polarized inputs, be inferior to the minimum conduction voltage of the PIN diode or diodes, which is usually between 0,5 and 0,7 V.

This therefore gives the possibility of eliminating the inverse polarization circuits from the selectors, thus allowing for the production of a cheaper product.

By using these construction techniques, the voltage, which must be created on the 7 resistances or on those of 27, necessary for the inverse polarization of one or more 23 chains, can be obtained by using one or more different components, such as ZENER diodes or equivalent, suitably unpaired from the radio frequencies.

Commutation takes place due to the fact that a voltage is formed across these components, independently from how this is obtained.

The 1 selector of this present invention can also be used as a distributor, with the same characteristics.

The radio frequency signals applied can in fact, pass in the selector both from the 4 inputs and from output 5, and from output 5 to the 4 inputs; in this latter case this can be used as a distributor of RF signals coming from a single source.

In fact, by applying radio frequency signals on output 5, it is possible to distribute them in turns on the 4 inputs of selector 1 with the same results, to be more precise: with a low loss of the signals which pass in the chosen input and elevated attenuation of the RF signals directed towards the other 4 inputs.

18.

CLAIMS                        **0194468**

1) Electronic selector switch for the selection and eventual damping of radio and television frequencies preferably operating on the 40 + 200 MHz band and utilizable for the recption of radio and television signals either by ether or cable characterized by the fact of having at least two 23 chains, each containing one or more 3 semiconductor electronic devices placed in series and by the fact that every 23 chain is connected with equal or contrary polarization to that or those preceding it, on one extremity to the 4 input through isolating circuits, polarization and/or filter and on the other extremity through isolating circuits, polarization and/or filter on output 5.

2) Electronic selector as in claim 1), in which every 23 chain is connected to the others in a 5A point, having the same polarity or inverse polarity to the said 5A point, it is directly connected or through polarization circuits, filter and/or isolation with output 5.

3) Electronic selector as in claims 1) and 2) characterized by the fact that each 23 chain contains one or more 3 PIN diodes in series.

4) Electronic selector according to any one of the preceding claims, characterized by the fact that the 23 chains are fed in turn by equal or different voltages, both positive and negative and that to the feeding of every chain corresponds the commutation of the relative Input 4 and output 5 and the interdiction of all the other outputs.

5) Electronic selector according to any one of the preceding claims in which the commutation current of the various 4 inputs is of weak strength and that the said current, present in an input chain in conduction, inversely polarizes the other chain or chains, with relative exclusion of the corresponding entries.

6) Electronic selector according to claim 5) in which the inversely polarized chain or chains constitute an attenuation device of the signal received, whilst the chain which is directly polarized is in conduction.

7) Electronic selector according to any one of the preceding claims, in which each chain is realized in one or two stages, every one of which is shielded with respect to the radio frequencies of the other stages.of the same chain.

8) Electronic selector according to any one of the preceding claims from 1) to 6) in which every chain is shielded with respect to the radio frequencies of the other chains.

9) Electronic selector according to any one of the preceding claims in which applied radio frequency signals pass from the inputs to the output or viceversa from the output to the inputs.

10) Electronic selector according to any one of the preceding claims, characterized by the fact that on the inputs and on the output attenuators or RF signal amplifiers are paired, eventually fed through the same voltage or voltages as that of the selector.

Dott. GIOVANNI LECCE & ...

UFFICIO INTERNAZIONALE BREVETTI
PATENT AND TRADE MARK ATTORNEYS

EUROPEAN PATENT ATTORNEY: GIOVANNI LECCE

**0194468**

MILANO ..... June 23, 1985 .....

20123 MILANO
VIA G. NEGRI, 10
☎ 865757-8693276     REGISTERED
LECPAT - MI
Tx 315672 LECPAT     EXPRESS

VS. RIF.

NS. RIF.   GL/gg/EP0861

EPA EPO-OEB
BG 1
Reçu:
3 0 JUN 1986

EUROPEAN PATENT OFFICE
Erhardtstrasse 27
D 8000 MUNCHEN 2

(Germania Occidentale)

Re: European Patent Application No. 86101959.4
filed on February 16, 1986 in the name of
Motta Tino Giuseppe, Motta Natale and Zappa Emilia

_____

Dear Sirs,

We wish to amend the following typing mistakes in the above patent application:

1. on page 1, line 9, please change "200 MHZ" to "2,000 MHZ";

2. on page 4, line 21 please add the words "attenuated of" before "15÷20";

3. on page 9, line 25 please change "10.000 V" to "10.000 times (the abbreviation V in Italian language means "volte"= times

4. on page 18, claim 1, line 3, please change "200 MHZ" to "2,000 MHZ";

5. On page 20 "Abstract", line 8, please change "200 MHZ" to "2,000 MHZ".

It will be noted in this regard that the Italian Patent Application n. 19762A/85, from which convention priority is claimed, supports the above amendments (see Italian Patent Application on page 1 - Riassunto - line 4 and on page 2 line 19, for the above requested amendments 1, 4 and 5; on page 12 line 13 for amendment 3; and on page 6 line 22 for amendment 2).

Yours faithfully,

Giovanni Lecce

TRIB. MI 138269/3457/19 - CCIA 772565 - CAP. L. 20.000.000 INT. VERS. - COD. FISC. E P. IVA 01579020155

Fig.1

0194468

Fig.2

0194468

FIG. 4

FIG. 3

FIG.5

FIG.6

FIG.7